# EUROPÄISCHE PATENTSCHRIFT

(11) **EP 1 038 355 B1**
(45) Veröffentlichungstag und Bekanntmachung des Hinweises auf die Patenterteilung: **31.07.2002**
(21) Anmeldenummer: 98962227.9
(22) Anmeldetag: 09.11.1998
(51) Int. Cl.: H03K 19/0175, G05F 3/24

(54) **PUFFERSCHALTUNG**
BUFFER CIRCUIT
CIRCUIT TAMPON

(30) Priorität: 11.12.1997 DE 19755130
(43) Veröffentlichungstag der Anmeldung: 27.09.2000
(73) Patentinhaber: Infineon Technologies AG, 81669 München (DE)
(72) Erfinder: FEURLE, Robert, D-85635 Höhenkirchen-Siegertsbrunn (DE); SAVIGNAC, Dominique, D-85737 Ismaning (DE); SCHNEIDER, Helmut, D-80993 München (DE)
(74) Vertreter: Epping Hermann & Fischer
(86) Internationale Anmeldenummer: DE9803268
(87) Internationale Veröffentlichungsnummer: WO9930419

(56) Entgegenhaltungen:
- EP-A- 0 310 359
- EP-A- 0 317 222
- JP-A- 6 215 570
- US-A- 5 030 848
- US-A- 5 422 591

## Beschreibung

Die Erfindung betrifft eine Pufferschaltung zum Puffern einer Versorgungsspannung einer integrierten Schaltung.

Derartige Pufferschaltungen enthalten üblicherweise Kondensatoren zum Puffern der Spannung. Weist der Kondensator einen Defekt auf, d.h., es fließt über ihn ein unerwünschter Leckstrom, kann die Pufferschaltung ihre Funktion nicht mehr erfüllen. Der defekte Kondensator verursacht dann nämlich einen Zusammenbruch der zu puffernden Spannung. Unter Defekt eines Kondensators wird im folgenden ein Zustand verstanden, bei dem ein Stromfluß zwischen den beiden Elektroden des Kondensators auftritt. Ein solcher Defekt kann beispielsweise durch Herstellungsfehler oder durch im späteren Betrieb auftretende Überspannungen mit der Folge einer Beschädigung des Dielektrikums des Kondensators bedingt sein.

Der Erfindung liegt die Aufgabe zugrunde, eine Pufferschaltung für eine Versorgungsspannung einer integrierten Schaltung anzugeben, die eine große Toleranz gegenüber Defekten von in der Pufferschaltung enthaltenen Pufferkondensatoren aufweist.

Diese Aufgabe wird mit einer Pufferschaltung gemäß Anspruch 1 gelöst. Vorteilhafte Aus- und Weiterbildungen der Erfindung sind Gegenstand von abhängigen Ansprüchen.

Erfindungsgemäß ist es vorgesehen, daß die Pufferschaltung zwischen einem ersten und einem zweiten Potentialknoten, zwischen denen eine zu puffernde Versorgungsspannung abfällt, eine Reihenschaltung aufweist, die wenigstens zwei Pufferkondensatoren beinhaltet. Ein zwischen den Kondensatoren angeordneter dritter Potentialknoten ist mit einer Zusatzschaltung verbunden, die sein Potential in der Weise beeinflußt, daß es auch bei Auftreten eines Leckstroms über einen der Pufferkondensatoren einen oberen und/oder unteren Grenzwert nicht überschreitet.

Die Reihenschaltung von zwei Kondensatoren zur Pufferung der Versorgungsspannung ermöglicht es, eine höhere Spannung zu Puffern, als dies mit nur einem einzelnen der beiden Kondensatoren möglich wäre. Ohne die erfindungsgemäße Zusatzschaltung fiele im Falle des Defekts eines der beiden Pufferkondensatoren auf Grund des damit verbundenen Spannungseinbruchs eine sehr hohe Spannung über dem noch intakten zweiten Kondensator ab. Dies würde in vielen Fällen eine Zerstörung auch dieses zweiten Kondensators zu Folge haben, so daß dann über beide Kondensatoren ein Kurzschlußstrom fließen würde. Die zu puffernde Versorgungsspannung würde dabei zusammenbrechen.

Die erfindungsgemäße Zusatzschaltung sorgt dafür, daß das Potential zwischen den beiden Pufferkondensatoren bei einem Defekt eines der Kondensatoren nicht allein von dessen Kurzschlußwiderstand abhängig ist, sondern zusätzlich auch von der Zusatzschaltung. Aufgrund der Begrenzung der bei Defekten auftretenden Änderungen des Potentials am dritten Potentialknoten wird erreicht, daß die über dem noch intakten Kondensator abfallende Spannung ebenfalls in ihrer Höhe begrenzt bleibt. Auf diese Weise werden Feldstärken vermieden, die eine Zerstörung des noch intakten Kondensators verursachen könnten. Somit bleibt vorteilhafterweise die Pufferschaltung wenigstens teilweise wirksam, auch wenn einer der beiden Pufferkondensatoren defekt ist und ohne daß es zu einem Zusammenbruch der zu puffernden Versorgungsspannung aufgrund eines Kurzschlusses über beide Kondensatoren der Pufferschaltung kommt.

Bei einer ersten Ausführungsform der Erfindung weist die Zusatzschaltung ein Widerstandselement auf, über das der dritte Potentialknoten mit einem im wesentlichen konstanten Potential verbunden ist. Das Potential am dritten Potentialknoten stimmt dann, bei intakten Pufferkondensatoren, im wesentlichen mit dem konstanten Potential überein. Ist einer der Pufferkondensatoren defekt, bestimmt sich das Potential am dritten Potentialknoten in Abhängigkeit vom Spannungsteilerverhältnis, das durch das Widerstandselement und den Kurzschlußwiderstand des defekten Pufferkondensators gebildet wird. Entsprechend ist der Wert des Widerstandselementes zu dimensionieren, so daß sich das Potential am dritten Potentialknoten bei Auftreten eines Defekts nur in den gewünschten Grenzen verändert. Die Dimensionierung des Widerstandselementes erfolgt dabei anhand von Kurzschlußwiderständen, die für die verwendeten Kondensatoren bei Vorliegen eines Defekts typisch sind.

Dimensioniert man die beiden Pufferkondensatoren in gleicher Weise, ist es günstig, den Wert des konstanten Potentials genau in die Mitte zwischen die Potentiale am ersten und am zweiten Potentialknoten zu legen. Dann fällt bei intakter Pufferschaltung über jedem der Pufferkondensatoren die halbe zu puffernde Versorgungsspannung ab und es fließt kein Strom über das Widerstandselement.

Das hochohmige Widerstandselement kann beispielsweise durch einen ohmschen Widerstand, eine Diode oder durch einen als Widerstand geschalteten Transistor realisiert sein.

Nach einer Weiterbildung der Erfindung ist der Widerstandswert des hochohmigen Widerstandelementes über einen Spannungsregler einstellbar, der auf diese Weise das Potential des dritten Potentialknotens regelt, so daß es den oberen bzw. den unteren Grenzwert nicht überschreitet. Dies bietet den Vorteil gegenüber einer Lösung mit nicht einstellbarem Widerstandselement, daß das Potential am dritten Potentialknoten für die unterschiedlichsten Kurzschlußwiderstände des defekten Kondensators stabil gehalten werden kann.

Bei einer zweiten Ausführungsform der Erfindung weist die Zusatzschaltung einen zwischen einem vierten und einem fünften Potentialknoten angeordneten Spannungsteiler auf, über dem eine im wesentlichen konstante Spannung abfällt, wobei der Spannungsteiler zwei Widerstandselemente beinhaltet, zwischen denen ein sechster Potentialknoten angeordnet ist, der mit dem dritten Potentialknoten verbunden ist. Besonders günstig ist es, wenn der vierte mit dem ersten und der fünfte mit dem zweiten Potentialknoten verbunden ist. Dann ist die über dem Spannungsteiler abfallende konstante Spannung mit der zu puffernden Versorgungsspannung identisch und es wird keine weitere konstante Spannung benötigt.

Besonders günstig ist es, wenn wenigstens eines, vorzugsweise aber beide Widerstandselemente des Spannungsteilers veränderbare Widerstandswerte aufweisen, wobei entsprechende Steuereingänge der Widerstandselemente mit einem Spannungsregler verbunden sind, der das Potential am dritten Potentialknoten über die Widerstandselemente regelt.

Die geschilderten Ausführungsformen der Erfindung, bei denen die Zusatzschaltung einen Spannungsregler aufweist, haben den großen Vorteil, daß das Potential am dritten Potentialknoten bei Defekt eines der Pufferkondensatoren mit großer Genauigkeit vorgegeben werden kann. Die Anpassung des Spannungsteilerverhältnisses für den dritten Knoten in Abhängigkeit vom Wert des Kurzschlußwiderstandes des defekten Kondensators verhindert eine Beschädigung des nicht defekten Kondensators für die unterschiedlichsten Werte des Kurzschlußwiderstandes des defekten Kondensators.

Die Erfindung ist insbesondere dann vorteilhaft, wenn die Pufferschaltung mehrere Reihenschaltungen aus je zwei Pufferkondensatoren der beschriebenen Art aufweist, bei denen der zwischen den Pufferkondensatoren liegende Potentialknoten entweder an eine separate Zusatzschaltung angeschlossen ist oder jeweils mit dem dritten Potentialknoten der ersten Reihenschaltung verbunden ist, so daß alle Reihenschaltungen durch nur eine Zusatzschaltung beeinflußt werden. Selbst wenn das Puffervermögen einer der Reihenschaltungen aufgrund eines Defektes eines ihrer Pufferkondensatoren eingeschränkt sein sollte, können dann die restlichen Reihenschaltungen die Pufferung der Versorgungsspannung nahezu uneingeschränkt gewährleisten.

Die Erfindung wird im folgendem anhand der Figuren näher erläutert. Es zeigen:

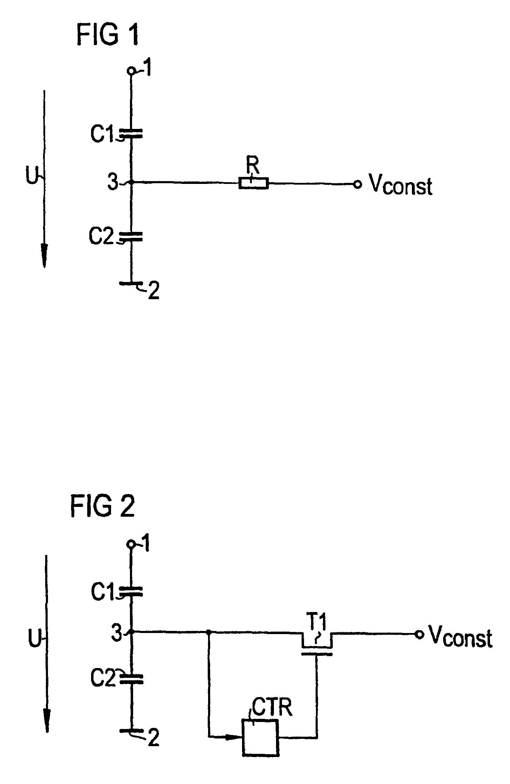

Figuren 1 bis 4 verschiedene Ausführungsbeispiele der erfindungsgemäßen Pufferschaltung.

Figur 1 zeigt einen erstes Ausführungsbeispiel der erfindungsgemäßen Pufferschaltung, bei der ein erster Potentiälknoten 1 über einen ersten Pufferkondensator C1 und einen zweiten Pufferkondensator C2 mit einem zweiten Potentialknoten 2 verbunden ist. Zwischen dem ersten 1 und dem zweiten 2 Potentialknoten fällt eine zu puffernde Versorgungsspannung U einer integrierten Schaltung ab, deren Bestandteil die dargestellte Pufferschaltung ist. Zwischen den beiden Kondensatoren C1, C2 ist ein dritter Potentialknoten 3 angeordnet, der über einen ohmschen Widerstand R mit einem konstanten Potential V_{const} verbunden ist. Der zweite Potentialknoten 2 hat Massepotential. Das konstante Potential V_{const} kann beispielsweise von der Versorgungsspannung U abgeleitet sein. Es sorgt gemeinsam mit dem Widerstand R dafür, daß sich bei einem Defekt eines der beiden Kondensatoren C1, C2 das Potential am dritten Potentialknoten 3 nur in gewissen Grenzen verändert. Das sich bei einem Defekt am dritten Potentialknoten 3 einstellende Potential ergibt sich aus dem Verhältnis des Spannungsteilers, der durch den Widerstand R und den Kurzschlußwiderstand des defekten Kondensators gebildet wird. Der Wert des Widerstandes R ist so dimensioniert, daß er gemeinsam mit einem typischen Wert für den Kurzschlußwiderstand des Kondensators das gewünschte Spannungsteilerverhältnis liefert. Typische Werte für Kurzschlußwiderstände von defekten Kondensatoren lassen sich durch Empirie feststellen.

Ohne die erfindungsgemäße Zusatzschaltung fiele bei Defekt eines der Kondensatoren, dessen Kurzschlußwiderstand dann sehr viel geringer ist als der (idealerweise) unendliche Widerstand des anderen, intakten Kondensators fast die gesamte Versorgungsspannung U über dem intakten Kondensator ab. Das Potential des dritten Potentialknotens 3 würde sich dabei sehr stark dem Potential eines der beiden Potentialknoten 1, 2 annähern. Der intakte Kondensator, über dem dann nahezu die gesamte Versorgungsspannung U abfiele, würde dann durch die damit verbundene hohe elektrische Feldstärke zerstört. Dies wird bei der Erfindung durch Beeinflussung des Potentials am dritten Potentialknoten vermieden.

Figur 2 zeigt ein zweites Ausführungsbeispiel der Pufferschaltung, das sich von demjenigen von Figur 1 darin unterscheidet, daß anstelle des ohmschen Widerstands R ein n-Kanal-Transistor T1 vorhanden ist, dessen Gate mit dem Ausgang eines Spannungsreglers CTR verbunden ist. Ein Eingang des Spannungsreglers CTR ist mit dem dritten Potentialknoten 3 verbunden. Der Spannungsregler CTR regelt das Potential am dritten Potentialknoten 3 durch Veränderung des Widerstandswertes des n-Kanal-Transitors T1, so daß sein Potential bei Defekt eines der Kondensatoren C1, C2 nahezu denselben Wert aufweist, wie bei intakten Kondensatoren. Durch die Regelung des Potentials des dritten Potentialknotens 3 wird erreicht, das die über dem intakten der beiden Kondensatoren C1, C2 abfallende Spannung unabhängig vom Zustand des anderen Kondensators ist, so daß er nicht ebenfalls zerstört wird. Dadurch, daß bei einem Defekt eines der beiden Kondensatoren eine Zerstörung des jeweils anderen Kondensators verhindert wird, bricht die zu puffernde Versorgungsspannung U nicht zusammen, und die integrierte Schaltung kann trotz Beeinträchtigung der Pufferschaltung weiterbetrieben werden.

Die Versorgungsspannung U kann bei einem aufgetretenen Defekt noch ausreichend gepuffert werden, wenn zusätzlich zu der in den Figuren dargestellten Reihenschaltung der beiden Kondensatoren C1, C2 mehrere weitere gleichartige Reihenschaltungen dieser parallel geschaltet sind, bei denen der zwischen den Kondensatoren liegende Potentialknoten mit dem dritten Potentialknoten 3 verbunden ist. Ist dann nur einer der beiden Kondensatoren einer der Reihenschaltungen defekt, versehen die übrigen Reihenschaltungen ihren Dienst aufgrund der Aufrechterhaltung des Potentials am dritten Potentialknoten 3 weitestgehend unbeeinträchtigt.

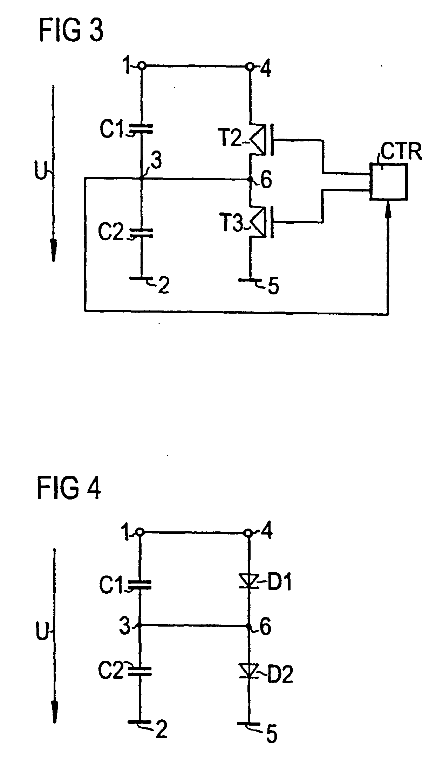

Figur 3 zeigt ein drittes Ausführungsbeispiel der Erfindung, bei dem zwischen einem vierten Potentialknoten 4 und einem fünften Potentialknoten 5 eine Reihenschaltung zweier Transistoren T2, T3 angeordnet ist, die einen Spannungsteiler bilden. Ein zwischen den Transistoren T2, T3 angeordneter sechster Potentialknoten 6 ist mit dem dritten Potentialknoten 3 verbunden. Fällt nun zwischen dem vierten Potentialknoten 4 und dem fünften Potentialknoten 5 eine konstante Spannung ab, bestimmt sich das Potential am dritten Potentialknoten 3 weitestgehend aus dem Spannungsteilerverhältnis der beiden Transistoren T2, T3. Als konstante Spannung kann dabei die zu puffernde Versorgungsspannung U verwendet werden, so daß, wie in Figur 3 gezeigt, der erste mit dem vierten und der zweite mit dem fünften Potentialknoten elektrisch verbundenen ist. Das Spannungsteilerverhältnis in Figur 3 ist über die Gates der Transistoren T2, T3 durch einen Spannungsregler CTR veränderbar. Dieser regelt wieder analog zu Figur 2 das Potential am dritten Potentialknoten 3 durch Veränderung des Spannungsteilerverhältnisses. Bei anderen Ausführungsformen der Erfindung kann auch lediglich einer der beiden Transistoren T2, T3 durch den Spannungsregler CTR in seinem Widerstandwert verändert werden.

Figur 4 zeigt ein viertes Ausführungsbeispiel der Erfindung bei dem gegenüber Figur 3 kein Spannungsregler CTR vorhanden ist, und die Transistoren T2, T3 durch Dioden D1, D2 ersetzt worden sind. Das Potential am dritten Potentialknoten 3 ergibt sich dann aus dem Spannungsteilerverhältnis der beiden Dioden. Anstelle von Dioden oder Transistoren können auch ohmsche Widerstände zur Bildung des Spannungsteilers verwendet werden. Die Funktionsweise des Gegenstands aus Figur 4 ist ähnlich derjenigen von Figur 1.

## Patentansprüche

1. Pufferschaltung zum Puffern einer zwischen zwei Potentialknoten (1, 2) anliegenden Versorgungspannung (U) einer integrierten Schaltung
- mit einer zwischen den beiden Potentialknoten (1, 2) angeordneten Reihenschaltung wenigstens zweier Pufferkondensatoren (C1, C2), zwischen denen ein dritter Potentialknoten (3) angeordnet ist,
- und mit einer mit dem dritten Potentialknoten (3) verbundenen Zusatzschaltung zur Beeinflussung des Potentials am dritten Potentialknoten (3) in der Weise, daß es bei Auftreten eines Leckstromes über einen der Kondensatoren (C1, C2) einen oberen und/oder unteren Grenzwert nicht überschreitet.

2. Pufferschaltung nach Anspruch 1,
deren Zusatzschaltung ein Widerstandselement (R; T1) aufweist, über das der dritte Potentialknoten (3) mit einem im wesentlichen konstanten Potential (V_{const}) verbunden ist.

3. Pufferschaltung nach Anspruch 2,
deren Zusatzschaltung einen Spannungsregler (CTR) aufweist, der das Potential des dritten Potentialknotens (3) durch Veränderung des Widerstandswertes des Widerstandselementes (T1) regelt.

4. Pufferschaltung nach Anspruch 1,
deren Zusatzschaltung einen zwischen einem vierten (4) und einem fünften (5) Potentialknoten angeordneten Spannungsteiler aufweist, über dem eine im wesentlichen konstante Spannung abfällt,
wobei der Spannungsteiler zwei Widerstandselemente (T2, T3; D1, D2) beinhaltet, zwischen denen ein sechster Potentialknoten (6) angeordnet ist, der mit dem dritten Potentialknoten (3) verbunden ist.

5. Pufferschaltung nach Anspruch 4,
deren Zusatzschaltung einen Spannungsregler (CTR) aufweist, der das Potential des dritten Potentialknotens (3) durch Veränderung des Widerstandswertes wenigstens eines der Widerstandselemente (T2, T3) regelt.

6. Pufferschaltung nach Anspruch 4 oder 5,
bei der der vierte (4) mit dem ersten (1) und/oder der fünfte (5) mit dem zweiten (2) Potentialknoten verbunden ist.

## Claims

1. Buffer circuit for buffering a supply voltage (U) of an integrated circuit, said supply voltage being present between two potential nodes (1, 2),
- having a series circuit comprising at least two buffer capacitors (C1, C2), between which a third potential node (3) is arranged, said series circuit being arranged between the two potential nodes (1, 2),
- and having an additional circuit connected to the third potential node (3) and serving to influence the potential at the third potential node (3) in such a way that it does not exceed an upper and/or lower limit value when a leakage current occurs via one of the capacitors (C1, C2).

2. Buffer circuit according to Claim 1,
whose additional circuit has a resistance element (R; T1), via which the third potential node (3) is connected to an essentially constant potential (V_{const}).

3. Buffer circuit according to Claim 2,
whose additional circuit has a voltage regulator (CTR), which regulates the potential of the third potential node (3) by varying the resistance of the resistance element (T1).

4. Buffer circuit according to Claim 1,
whose additional circuit has a voltage divider which is arranged between a fourth (4) and a fifth (5) potential node and across which an essentially constant voltage is dropped,
where the voltage divider comprises two resistance elements (T2, T3; D1, D2), between which a sixth potential node (6) connected to the third potential node (3) is arranged.

5. Buffer circuit according to Claim 4,
whose additional circuit has a voltage regulator (CTR), which regulates the potential of the third potential node (3) by varying the resistance of at least one of the resistance elements (T2, T3).

6. Buffer circuit according to Claim 4 or 5,
in which the fourth potential node (4) is connected to the first potential node (1) and/or the fifth potential node (5) is connected to the second potential node (2).

## Revendications

1. Circuit tampon destiné à tamponner une tension (U) d'alimentation s'appliquant entre deux noeuds (1, 2) de potentiel d'un circuit intégré
- comprenant un circuit série monté entre les deux noeuds (1, 2) de potentiel et ayant au moins deux condensateurs (C1, C2) tampon entre lesquels se trouvent un troisième noeud (3) de potentiel,
- et comprenant un circuit supplémentaire qui est relié au troisième noeud (3) de potentiel et qui est destiné à influencer le potentiel sur le troisième noeud (3) de potentiel, de façon à ce que, lorsqu'il se produit un courant de fuite sur l'un des condensateurs (C1, C2) une valeur limite supérieure et/ou inférieure ne soit pas dépassée.

2. Circuit tampon suivant la revendication 1, dont le circuit supplémentaire comporte un élément (R ; T1) résistant, par lequel le troisième noeud (3) de potentiel est relié à un potentiel (V_{const}) sensiblement constant.

3. Circuit tampon suivant la revendication 2, dont le circuit supplémentaire comporte un régulateur (CTR) de tension, qui règle le potentiel du troisième noeud (3) de potentiel en modifiant la valeur de la résistance de l'élément (T1) résistant.

4. Circuit tampon suivant la revendication 1, dont le circuit supplémentaire comporte un diviseur de tension interposé entre un quatrième noeud (4) et un cinquième noeud (5) de potentiel, diviseur aux bornes duquel chute une tension sensiblement constante,
le diviseur de tension comportants deux éléments (T2, T3 ; D1, D2) résistants entre lesquels se trouve un sixième noeud (6) de potentiel, qui est relié au troisième noeud (3) de potentiel.

5. Circuit tampon suivant la revendication 4, dont le circuit supplémentaire comporte un régulateur (CTR) de tension, qui règle le potentiel du troisième noeud (3) de potentiel en modifiant la valeur de la résistance d'au moins l'un des éléments (T2, T3) résistants.

6. Circuit tampon suivant la revendication 4 ou 5, dans lequel le quatrième noeud (4) de potentiel est relié au premier noeud (1) de potentiel et/ou le cinquième noeud (5) de potentiel est relié au deuxième noeud (2) de potentiel.
